(19)

Europäisches
Patentamt
European
Patent Office
Office européen
des brevets

(11) **EP 3 364 542 A1**

(12) **EUROPEAN PATENT APPLICATION**
published in accordance with Art. 153(4) EPC

(43) Date of publication:
**22.08.2018 Bulletin 2018/34**

(21) Application number: **16877572.4**

(22) Date of filing: **05.12.2016**

(51) Int Cl.:
**H03M 13/29** *(2006.01)*    **H03M 13/13** *(2006.01)*

(86) International application number:
**PCT/CN2016/108511**

(87) International publication number:
**WO 2017/107761 (29.06.2017 Gazette 2017/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **23.12.2015  CN 201510995761**
**21.09.2016  CN 201610847488**

(71) Applicant: **Huazhong University of Science and Technology**
**Wuhan City**
**Hubei 430074 (CN)**

(72) Inventors:
• **QU, Daiming**
  **Wuhan**
  **Hubei 430074 (CN)**
• **WANG, Tao**
  **Wuhan**
  **Hubei 430074 (CN)**
• **JIANG, Tao**
  **Wuhan**
  **Hubei 430074 (CN)**

(74) Representative: **Hryszkiewicz, Danuta**
**Matthias Scholl, Inc.**
**Friedrichstrasse 123**
**10117 Berlin (DE)**

(54) **ERROR CORRECTION CODING METHOD BASED ON CASCADING OF POLAR CODES AND REPETITION CODES OR MULTI-BIT PARITY CHECK CODES**

(57)    An error correction coding method based on cascading of polar codes and repetition codes or multi-bit parity check codes. On a sending side, repetition codes or multi-bit parity check codes are used as external codes, and polar codes are used as internal codes. A reception side coder performs coding by using a corrected SCL coding algorithm. For error correction performance, frame error rate performance of the provided coding method remarkably exceeds frame error rate performance of polar codes in use of an SCL coding algorithm or an RC-aided SCL coding algorithm. In the engineering implementation, repetition codes or multi-bit parity check codes are used as external codes, so that coding is simple. A corrected SCL coding algorithm is used in coding, the complexity of the corrected SCL coding algorithm is not increased compared with that of an original SCL coding algorithm, thereby facilitating engineering implementation.

EP 3 364 542 A1

**FIG. 2**

Printed by Jouve, 75001 PARIS (FR)

**Description**

The disclosure relates to the field of error-correction coding, and more particularly to an error-correction coding method based on concatenation of polar codes and repetition codes or multi-bit parity-check codes.

Polar coding are the first coding schemes that probably achieve the Shannon capacity with low encoding and decoding complexity, which makes it possible to put into practice. Simulation results show that a Successive Cancellation List (SCL) decoder can achieve the error correction performance of maximum likelihood decoder under a low complexity of $O(L \cdot N\log(N))$ (where $L$ is the maximum number of paths in the SCL decoder and $N$ is the codeword length). However, the error correction performance of polar codes with short and moderate codeword length under SCL decoding algorithm is mediocre, which is far from Shannon capacity, and cannot be balanced by simply increasing the maximum number of paths.

With regard to traditional polar code concatenation methods, the concatenated Low-Density Parity-Check (LDPC) codes do not exhibit an improved error correction performance compared to the Cyclical Redundancy Check (CRC)-concatenated polar codes under the CRC-aided SCL decoder, because the characteristics of the resultant concatenated codes are not suitable for the SCL decoder. The concatenated CRC codes require additional CRC checking circuits, which involves added hardware costs, and the error correcting capability is limited. Therefore, conventional polar concatenation schemes restrict the engineering applications of polar codes.

In view of the above-described problems, it is one objective of the invention to provide an error-correction coding method based on concatenation of polar codes and repetition codes or multi-bit parity-check codes. The method aims to concatenate polar codes with an outer encoder of a low coding complexity to improve the error correcting capability of the polar code using a SCL decoding algorithm without increasing the decoding complexity and storing complexity.

To achieve the above objective, in accordance with one embodiment of the invention, there is provided an error-correction coding method based on concatenation of polar codes and repetition codes or multi-bit parity-check codes, the method comprising:

(1) performing repetition coding or multi-bit parity-check coding on an information bit sequence, to yield an outer codeword;

(2) sequentially mapping a first bit to a last bit of the outer codeword on a first unfrozen bit to a last unfrozen bit of a polar code, to yield an unfrozen bit sequence; and

(3) performing polar coding on the unfrozen bit sequence, to yield a concatenated codeword.

In a class of this embodiment, in (1), an information bit to be repeated is repeated one or more times during the repetition coding.

In a class of this embodiment, in (2), in the process of mapping, the bit channel capacities of unfrozen bit channels mapped by repeated bits are lower than those of the unfrozen bit channels mapped by unrepeated bits, where the repeated bits denote the information bits that are repeated in the repetition coding, and the unrepeated bits denote the information bits that are not repeated.

In a class of this embodiment, in (2), in the process of mapping, the indexes of the unfrozen bits mapped by the repeating bits of the outer codeword are greater than the index of the unfrozen bit mapped by the repeated bit corresponding to the repeating bits, where the repeating bits denotes the bits in the repetition code that repeat the repeated bit.

In a class of this embodiment, the repeating bits of the outer codeword are distributed uniformly or approximately uniformly in the unfrozen bit sequence obtained in (2).

In a class of this embodiment, by dividing the unfrozen bit sequence into $S$ segments in the order of the indexes, the repeating bits of the outer codeword are mapped to $K_h$ unfrozen bit channels of the lowest bit channel capacities in each segment, with the same number or approximately the same number of repeating bits in each segment, such that the repeating bits of the outer codeword are distributed uniformly or approximately uniformly in the unfrozen bits, where $h = 1,2,...,S$.

In a class of this embodiment, the outer code is replaced with an inverted repetition code. When the repeated bit is 1, the repeating bit of the inverted repetition code is 0, and when the repeated bit is 0, the repeating bit of the inverted repetition code is 1;

Assume that the repeated bit is repeated $K$ times, the number of inversed repeating bits out of the $K$ repeating bits obtained by repetition coding is 0-$K$.

In a class of this embodiment, certain bits at the end of the outer codeword are used as parity bits, and each of the parity bits serves as an even or odd-parity bit for the information bits, where an even parity bit denotes a bit whose value is 0(or 1) if the number of 1s in its corresponding information bits is even (or odd), an odd parity bit denotes a bit whose value is 1(or 0) if the number of 1s in its corresponding information bits is even (or odd).

In a class of this embodiment, the error-correction coding method further comprises a decoding process as follows:

(4) deciding an original information bit according to the SCL decoding algorithm; and deciding the repeating bit directly based on a decision result of the repeated bit.

In a class of this embodiment, the decoding process for the error-correction coding method described above comprises:

Step (4.1) determining whether $i$ is less than or equal to $N$; and if so, proceeding to Step (4.2), otherwise, proceeding to Step (4.7);

where $N$ is the codeword length of the concatenated code, and $i$ is the index of the $i$th bit currently being decoded, and has an initial value of 1 and is assigned with a positive integer from 1 to $N$;

Step (4.2) determining whether $u_i$ is a frozen bit, and if so, proceeding to Step (4.3), otherwise, proceeding to Step (4.4), where $u_i$ is the $i$th bit in the polar encoding bit sequence $u_1^N$ and $u_1^N$ is a row vector $(u_1, u_2, u_3, ..., u_N)$ in $1 \times N$;

Step (4.3) setting the decision value for $u_i$ on each path to the value of a known frozen bit, letting $i = i + 1$, and returning to Step (4.1);

Step (4.4) determining whether $u_i$ is a repeating bit of the $j(1 \leq j \leq K)$th repetition code, and if so, proceeding to (4.5), otherwise, proceeding to (4.6), where $K$ is the number of repeated bits in the outer code;

Step (4.5) setting the decision value for the repeating bits $u_i$ on each current path to the decision value of the repeated bit corresponding to $u_i$ on the path, specifically, $\hat{u}_i = \hat{u}_{\min(A_{T_j})}$, letting $i = i + 1$, and returning to Step (4.1);

where $T_j$ is a set of indexes of all the information bits in the $j$th repetition code in the outer codeword, $A_{T_j}$ is a set of indexes of all the information bits in the $j$th repetition code in the polar encoding bit sequence $u_1^N$ after outer codeword mapping, and $\min(A_{T_j})$ is the minimum element in the value set $A_{T_j}$ and corresponds to the repeated bit in the $j$th repetition code; throughout this disclosure, $\min(X)$ denotes the minimum value in the value set $X$;

Step (4.6) denoting the number of current paths as $L'$, obtaining $2L'$ subpaths by assigning a value of 0 or 1 to $u_i$ on each current path, and determining whether $2L' \leq L$ is satisfied, and if so, reserving $2L'$ subpaths, otherwise, reserving $L$ subpaths with the maximum path metrics, letting $i = i + 1$ and returning to Step (4.1);

where the path metrics of the $2L'$ subpaths are respectively the probabilities $W_N^{(i)}(y_1^N, \hat{u}_1^{i-1} | 0)$ or $W_N^{(i)}(y_1^N, \hat{u}_1^{i-1} | 1)$ of assigning 0 or 1 to $u_i$ on the paths, $L$ is the maximum number of paths in the SCL decoding algorithm;

Step (4.7) obtaining a decoding result by outputting a decision sequence $\hat{u}_1^N$ corresponding to the path with the maximum path metric out of the $L$ paths.

In a class of this embodiment, the parity bits of the outer codeword obtained by performing multi-bit parity-check coding on the information bit sequence in (1) are concentrated at the end of the outer codeword;

the set of indexes of the parity bits is $P = \{M + 1, M + 2, M + 3, ..., M + K\}$, and the elements in the set $P$ represent the bit indexes in the outer code where the parity bits are located. That is, in the codeword $x_1^{M+K}$ generated by an outer encoder, the bit sequence $x_1^M$ is comprised of information bits, and the bit sequence $x_{M+1}^{M+K}$ is comprised of parity bits;

where $M$ is the number of information bits, and $K$ is the number of parity bits .

In a class of this embodiment, the parity bits of the outer codeword obtained by performing multi-bit parity-check coding on the information bit sequence in (1) are distributed uniformly in the outer codeword;

the interval between adjacent parity bits is $\left\lfloor \dfrac{M+K}{K} \right\rfloor$, and the set of indexes of the parity bits is

$$P = \left\{ \left\lfloor \frac{M+K}{K} \right\rfloor \cdot j, j = 1, 2, 3 \ldots, K \right\};$$

where $M$ is the number of information bits, $K$ is the number of parity bits, $M + K$ is the codeword length of the outer code, and $\lfloor x \rfloor$ is a floor function of $x$.

In a class of this embodiment, the parity bits of the outer codeword obtained by performing multi-bit parity-check coding on the information bit sequence in (1) are non-uniformly distributed in the outer codeword.

In a class of this embodiment, in (1), the closer to the beginning of the outer codeword, the more dispersed the distribution of the parity bits, and the closer to the end of the outer codeword, the more concentrated the distribution of the parity bits. Therefore, a set $P$ of indexes of the parity bits are obtained according to this characteristic of parity bit location distribution.

In a class of this embodiment, assuming that the number of parity bits concentrated at the end of the outer codeword is $K_1$, and the number of the other parity bits distributed uniformly is $K - K_1$, then the set of indexes of the parity bits is:

$$P = \left\{ P_1 \bullet P_2 \mid P_1 = \{M + K - K_1 + 1, M + K - K_1 + 2, \ldots, M + K\}, P_2 = \left\{ \left\lfloor \frac{M + K - K_1}{K - K_1} \right\rfloor \cdot j, j = 1, 2, 3, \ldots, K - K_1 \right\} \right\};$$

where $M$ is the number of information bits, and $K$ is the number of parity bits.

In a class of this embodiment, when multi-bit parity-check coding is performed on the information bit sequence in (1), the parity bit is used only to check the information bits before and not the information bits after.

In a class of this embodiment, the outer code may be replaced with a multi-bit odd-parity code, whose parity bits are odd parity bits.

In a class of this embodiment, the decoding process for the coding method described above is performed by using a modified SCL decoding algorithm. Specifically, in decoding an information bit, bit decision is performed according to the SCL decoding algorithm, and in decoding a parity bit, decision is made by checking result based on the decision values of the information bits in the parity function containing the parity bit, where a parity function denotes the mathematical relationship between a parity bit and its corresponding information bits.

In a class of this embodiment, the decoding process comprises:

Step 1: determining whether $i$ is less than or equal to $N$, and if so, proceeding to Step 2, otherwise, proceeding to Step 7, where $N$ is the codeword length of the concatenated code, and $i$ is the index of the $i^{th}$ bit being decoded, and has an initial value of 1 and is assigned with a positive integer from 1 and $N$;

Step 2: determining whether $u_i$ is a frozen bit, and if so, proceeding to Step 3, otherwise, proceeding to Step 4, where $u_i$ is the $i^{th}$ bit in the polar encoding bit sequence;

Step 3: setting the decision value for $u_i$ on each current path to the value of a known frozen bit, letting $i = i + 1$, and returning to Step 1;

Step 4: determining whether $u_i$ is the $j(j = 1,2,\ldots,K)^{th}$ parity bit, and if so, proceeding to Step 5, otherwise, proceeding to Step 6, where $K$ is the number of parity bits;

Step 5: obtaining a decision value for $u_i$ on each current path by checking result based on the decision values of the information bits on the path: $\hat{u}_i = \left( \sum_{h \in A_{T_j} \backslash \max(A_{T_j})} \hat{u}_h \right) \bmod 2$, letting $i = i + 1$, and returning to Step 1; where $T_j$ is a set of indexes of all the information bits in the $j^{th}$ parity function in the outer code, and the outer code contains $K$ parity functions, each of which consists of a parity bit and the information bits corresponding to the parity bit, and the $j^{th}$ parity function denotes a parity function containing the $j^{th}$ parity bit, $A_{T_j}$ is a set of indexes of all the information bits in the $j^{th}$ parity function in the polar encoding bit sequence $u_1^N$ after outer codeword mapping, $\max(A_{T_j})$ denotes the maximum element in the value set $A_{T_j}$, and it is the index of the parity bit in the $j^{th}$ parity function mapped into $u_1^N$; $h$ is a temporary variable in said sum operation, denoting each element in the set $A_{T_j} \backslash \max(A_{T_j})$ sequentially,

and $A_{T_j} \setminus \max(A_{T_j})$ denotes the difference between the value sets $A_{T_j}$ and $\max(A_{T_j})$, where $A_{T_j} \setminus \max(A_{T_j}) = \{\lambda | \lambda \in A_{T_j}, \lambda \neq \max(A_{T_j})\}$;

Throughout this disclosure, $\max(X)$ denotes the maximum element in the value set $X$, and $\{X \setminus Y\}$ denotes the difference between the value sets $X$ and $Y$, i.e., $\{X \setminus Y\} = \{\lambda | \lambda \in X, \lambda \notin Y\}$;

Step 6: denoting the number of current paths as $L'$, and obtaining $2L'$ subpaths by assigning a value of 0 or 1 to $u_i$ on each current path, where the path metrics for the $2L'$ subpaths are respectively the probabilities $W_N^{(i)}(y_1^N, \hat{u}_1^{i-1} \mid 0)$

or $W_N^{(i)}(y_1^N, \hat{u}_1^{i-1} \mid 1)$ of assigning 0 or 1 to $u_i$ on the paths, and $y_1^N$ denotes the received vector;

if $2L' \leq L$, reserving $2L'$ subpaths, otherwise, if $2L' > L$, reserving $L$ subpaths with the maximum path metrics, letting $i = i + 1$ and returning Step 1;

where $L$ is the maximum number of paths in the SCL decoding algorithm;

Step 7: outputting the decision sequence $\hat{u}_1^N$ corresponding to the path with the maximum path metric out of the $L$ paths;

Step 8: end.

In general, compared with conventional techniques, the above-described technical solution conceived by the disclosure can achieve the following beneficial effects:

(1) The present scheme improves the error correcting capability of the polar code significantly;

The non-concatenated polar code of a short-to-moderate codeword length that uses a SCL decoding algorithm has an error correcting capability approaching the decoding capability of a maximum-likelihood decoder. Its error correcting capability is limited. Furthermore, even if the maximum number of paths in the SCL decoding algorithm is increased, the Frame Error Rate cannot be improved significantly. Also, increasing the maximum number of paths linearly increases the storing complexity and the decoding complexity of the algorithm, which is not beneficial for engineering implementation. Using a SCL decoding algorithm with the same maximum number of paths, the concatenated scheme provided by the disclosure exhibits an error correcting capability that is significantly improved over that of a non-concatenated polar code, and also outperforms the CRC-concatenated polar code.

(2) The present scheme causes no noticeable increase in decoding complexity and storing complexity;

In terms of the scheme concatenating a polar code with a multi-bit parity-check code, the essential difference between the modified SCL decoding algorithm adopted by the present solution and the original SCL decoding algorithm lies in that: the present algorithm decodes the parity bit directly by checking result based on the decision values of the information bits in the parity function. Since the number of parity functions and the length of the parity function are much smaller than the concatenated codeword length, the increase in decoding complexity is negligible. Although the present solution involves a slight increase in the storing complexity, that is, the parity functions for the outer code need to be stored in both the encoder and the decoder, the storage space occupied by the parity functions is rather small for the overall system since the number of parity functions and the length of the parity function for the outer code are much smaller than the concatenated codeword length. In terms of the solution concatenating a polar code with a repetition code, the essential difference lies in that the present algorithm decodes the repeating bit directly by decision result of the repeated bit. Compared with decoding by using a conventional SCL decoding algorithm, this modified decoding method according to the disclosure simply determines the value of the repeating bit as the value of the repeated bit, which involves operational complexity that is similar to that of decision of a frozen bit as 0 according to the conventional SCL algorithm. Therefore, the operational complexity is not increased.

(3) The outer code of the present solution is simple and easy to be implemented;

The present solution uses a repetition code or a multi-bit parity-check code as the outer code. Compared with solutions using other outer codes, the method according to the disclosure allows for a simple design of the hardware circuit in the outer encoder, thereby facilitating engineering implementation.

FIG. **1** is a schematic view showing a decoding process of a polar code with a codeword length of 4 by using a conventional SCL decoding algorithm;

FIG. **2** is a flow diagram of the encoding and decoding process in an error-correction coding method based on concatenation of polar codes and repetition codes or multi-bit parity-check codes according to the disclosure;

FIG. **3** is a schematic view showing a decoding process of an error-correction coding method based on concatenation of repetition codes and polar codes with a codeword length of 4;

FIG. **4** is a schematic view showing an encoding process of an outer codeword in an error-correction coding method concatenating a polar code with a repetition code according to an embodiment of the disclosure; and

FIG. **5** shows three examples of determining the locations of parity bits in a parity-check code according to an embodiment of the disclosure.

For further illustrating the invention, examples detailing an error-correction coding method based on concatenation of polar codes and repetition codes or multi-bit parity-check codes are described below. It should be noted that the following examples are intended to describe and not to limit the invention.

For a polar code of a codeword length of $N$ and with a number $M$ of transmitted information bits, polar coding is performed by polarizing $N$ independent identically distributed channels into $N$ bit channels by the channel polarization. Of the $N$ bit channels, the information bits are transmitted over the $M$ bit channels with the largest bit channel capacities, which are referred to as unfrozen bit channels, and a bit transmitted over an unfrozen bit channel is referred to as an unfrozen bit. The other ($N$ - $M$) bit channels are referred to as frozen bit channels, and a bit transmitted over a frozen bit channel is referred to as a frozen bit.

The polar encoding bit sequence is $u_1^N = (u_1, u_2, u_3, ..., u_N)$. Bits $u_1$ to $u_N$ are transmitted sequentially over the 1st to the $N$th bit channels. The set of indexes of the unfrozen bits in $u_1^N$ is $A$ = {$a_1, a_2, a_3, ..., a_M$} $\subseteq$ {1,2,3,...,$N$}. The elements in the set $A$ satisfy the condition that when $1 \le i < j \le M$, then $a_i < a_j$. The set of indexes of the frozen bits in $u_1^N$ is $A^c$;

The unfrozen bit sequence is $u_A = (u_{a1}, u_{a2}, u_{a3}, ..., u_{aM})$. The frozen bits in the polar code are known at both the transmitter and the receiver. For symmetric channels, the frozen bit sequence $u_{A_c}$ is set to a sequence of all 0s. If $M$ information bits are known, the unfrozen bit sequence $u_A$ can be determined, and therefore the polar encoding bit sequence $u_1^N$ can also be determined. The polar codeword is $c_1^N = u_1^N G_N$, where $G_N$ is a polar code generator matrix.

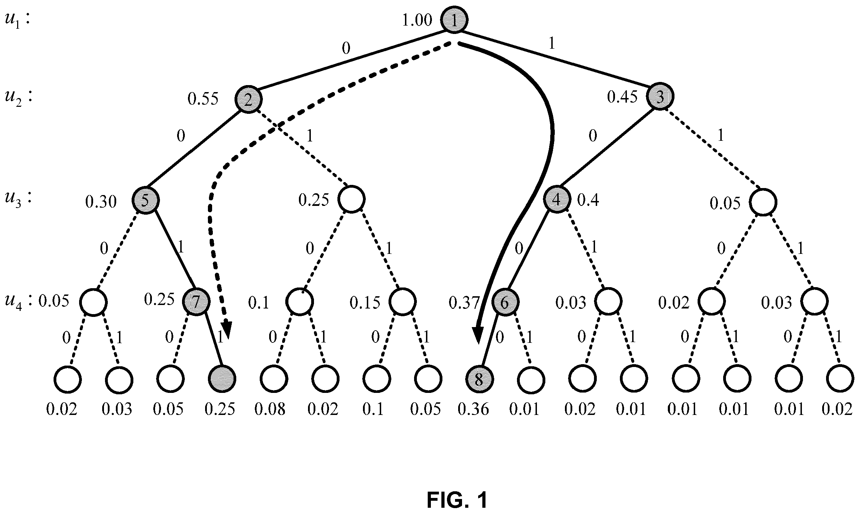

In decoding, the SCL decoding algorithm decides the bits $u_1$ to $u_N$ sequentially. During decoding by using the SCL algorithm, at most $L$ decoding paths may be reserved in the decoder list. When decoding $u_i$, each path is uniquely identified by the sequence $\hat{u}_1^{i-1}$ that has been decoded on the path. FIG. **1** is a schematic view showing a decoding process of a polar code with a codeword length of 4 by using a SCL decoding algorithm, where $u_2$ is a frozen bit, ($u_1, u_3, u_4$) are unfrozen bits, and the maximum number of paths is $L$ = 2. In decoding, the frozen bit $u_2$ on each path is determined as 0, and unfrozen bits are determined based on the path metrics. The process comprises specifically the following steps:

In Step 1, it is determined whether $i$ is less than or equal to $N$. If so, proceed to Step 2. Otherwise, proceed to Step5. The initial value of $i$ is 1.

In Step 2, it is determined whether $u_i$ is a frozen bit. If so, proceed to Step3. Otherwise, proceed to Step 4.

In Step 3, the decision value for $u_i$ on each current path is set to 0. Let $i=i+1$, and return to Step 1.

In Step 4, the number of current paths is denoted as $L'$. A value of 0 or 1 may be assigned to $u_i$ on each current path so as to obtain $2L'$ subpaths. If $2L' \le L$, $2L'$ subpaths are reserved. If $2L' > L$, $L$ subpaths with the maximum path metrics are reserved. Let $i=i+1$, and return to Step 1.

The path metrics for each of the $2L'$ subpaths are respectively the probabilities of assigning a value of 0 or 1 to $u_i$ on the path: $W_N^{(i)}(y_1^N, \hat{u}_1^{i-1} \mid 0)$ or $W_N^{(i)}(y_1^N, \hat{u}_1^{i-1} \mid 1)$. $L$ is the maximum number of paths in the SCL decoder, and $y_1^N$ denotes the received vector.

In Step 5, a decision sequence $\hat{u}_1^N$ for the path with the maximum path metric out of the $L$ paths is output. The

unfrozen bit sequence $\hat{u}_A$ in the decision sequence $\hat{u}_1^N$ is the decoding result for the information bit sequence in the polar code.

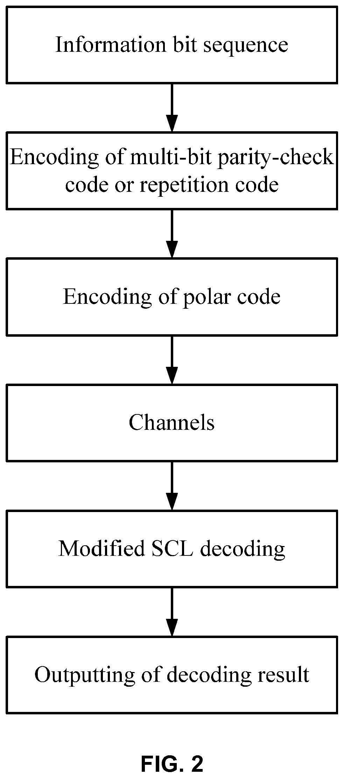

FIG. **2** shows a flow diagram of an error-correction coding method concatenating a polar code with a repetition code or multi-bit parity-check code according to the disclosure, specifically comprising the following steps.

(1) performing repetition coding or multi-bit parity-check coding on an information bit sequence, to yield an outer codeword;

(2) sequentially mapping a first bit to a last bit of the outer codeword on a first unfrozen bit to a last unfrozen bit of a polar code, to yield an unfrozen bit sequence; and

(3) performing polar coding on the unfrozen bit sequence, to yield a concatenated codeword.

The error-correction coding method concatenating a polar code with a repetition code and the error-correction coding method concatenating a polar code with a multi-bit parity-check code are explained below.

The error-correction coding method concatenating a polar code with repetition codes comprises the following steps.

Step 1: Encoding by an outer encoder

For a concatenation system with a codeword length $N$, a number of information bits $M$, a number of repeated bits $K_1(K_1 \le M)$, and a number of repeating bit $K_2(K_2 \ge K_1)$, the input of the outer encoder is $M$ information bits and the length of the output outer codeword is $M + K_2$, where the repeated bits denote the information bits that are repeated in the repetition coding and the repeating bits denotes the bits in the repetition code that repeat the repeated bit. In the concatenation system of a polar code with repetition codes, the outer code contains $K_1$ repetition codes, each of which consists of a repeated bit and the repeating bits corresponding to the repeated bit, and the $j(1 \le j \le K_1)^{\text{th}}$ repetition code in the outer code denotes the repetition code containing the $j^{\text{th}}$ repeated bit;

The codeword obtained by the outer encoder is $x_1^{M+K_2} \cdot x_1^{M+K_2}$ contains $M$ information bits and $K_2$ repeating bits. Determination of the outer encoder is equivalent to determination of the indexes of the $K_1$ repeated bits in the outer codeword $x_1^{M+K_2}$ and the indexes of the repeating bits each corresponding to a repeated bit. The index of the $j(1 \le j \le K_1)^{\text{th}}$ repeated bit and the indexes of the corresponding repeating bits in the outer codeword are denoted as a set $T_j(1 \le j \le K_1)$. It is appreciated that each set $T_j$ identifies a $|T_j|$-element repetition code in the outer codeword. $|T_j|$ denotes the number of elements in the set $T_j$, and $|T_j| = 2$ indicates that $T_j$ identifies a two-element repetition code. The minimum element in the set $T_j$ denotes the index of the repeated bit, and the other elements denote the indexes of the repeating bits of the repetition code.

Taking an outer codeword in which each repetition code is a two-element repetition code as an example, i.e., $K_1 = K_2$, the construction of the set $T_j(1 \le j \le K_1)$ will be described. It is to be noted that the specific construction of the set $T_j(1 \le j \le K_1)$ is intended merely for illustration rather than limitation of the disclosure.

(1.1) segmentation of the outer codeword and determination of the number of repeating bits and repeated bits in each segment:

First, the outer codeword is divided into $S$ segments in the order of bit indexes, in such a manner that $K_1$ repeating bits are allotted equally to the $2^{\text{nd}}$ through the $S^{\text{th}}$ segments, where the number of repeating bits allotted to the $h(2 \le h \le S-1)^{\text{th}}$ segment is $\lfloor K_1 / (S-1) \rfloor$ (with $\lfloor x \rfloor$ representing a floor function of $x$), and the number of repeating bits allotted to the $h(h = S)^{\text{th}}$ segment is $K_1 - (S-2)\lfloor K_1/(S-1) \rfloor$ (such that each segment contains an integer number of repeating bits, and there is a total number of $K_1$ repeating bits);

The repeating bits in the $h(2 \le h \le S)^{\text{th}}$ segment are used to check the repeated bits in the $h - 1^{\text{th}}$ segment. The $h'(1 \le h' \le S - 2)^{\text{th}}$ segment contains a number of $\lfloor K_1 / (S - 1) \rfloor$ repeated bits, and the $h'(h' = S - 1)^{\text{th}}$ segment contains a number of $K_1 - (S - 2)\lfloor K_1 / (S - 1) \rfloor$ repeated bits;

(1.2) determination of the indexes of repeating bits and repeated bits in each segment based on the number of repeating bits and the number of repeated bits in each segment:

According to outer codeword mapping, the bit channel capacity of the unfrozen bit channel to which each bit in the outer codeword is mapped is known. The expression "bit with high (low) bit channel capacity" refers to "bit of the outer codeword that is transmitted over the unfrozen bit channel with high (low) bit channel capacity after outer codeword mapping".

The repeating bits are selected in such a manner that the $\lfloor K_1 /(S-1)\rfloor$ bits with the lowest bit channel capacities in the $h(2 \le h \le S - 1)^{\text{th}}$ segment are selected as the repeating bits, and the $K_1 - (S - 2)\lfloor K_1 / (S - 1)\rfloor$ bits with the lowest bit channel capacities in the $h(h = S)^{\text{th}}$ segment are selected as the repeating bits.

The repeated bits are selected in such a manner that with the repeating bits that have been selected in the $h'(1 \le h' \le S - 2)^{\text{th}}$ segment removed, the $\lfloor K_1 /(S-1)\rfloor$ bits with the lowest bit channel capacities out of the remaining bits are selected as the repeated bits in the segment; and with the repeating bits that have been selected in the $h'(h' = S - 1)^{\text{th}}$ segment removed, the $K_1 - (S - 2)\lfloor K_1 /(S-1)\rfloor$ bits with the lowest bit channel capacities out of the remaining bits are selected as the repeated bits in the segment;

(1.3) pairing the repeating bits in the $h(2 \le h \le S)^{\text{th}}$ segment with the repeated bits in the $h - 1^{\text{th}}$ segment, in such a manner that the repeating bit with the lowest bit channel capacity in the $h(2 \le h \le S)^{\text{th}}$ segment is paired with the repeated bit with the lowest bit channel capacity in the $h - 1^{\text{th}}$ segment, so that a set $T_j$ is constructed from the indexes of the corresponding repeating bits and repeated bits; then pairing the repeating bit with the second lowest bit channel capacity in the $h(2 \le h \le S)^{\text{th}}$ segment with the repeated bit with the second lowest bit channel capacity in the $h - 1^{\text{th}}$ segment, and so on, until all the $K_1$ repeated bits have been paired so as to obtain $K_1$ sets $T_j(1 \le j \le K_1)$ of two-element repetition codes;

(1.4) outer encoding is based on the sets $T_j(1 \le j \le K_1)$, that is, the value of the repeating bits with indexes $\{T_j \setminus \min(T_j)\}(1 \le j \le K_1)$ in the outer codeword is equal to the value of the repeated bit with index $\min(T_j)(1 \le j \le K_1)$, i.e., $x_i = x_{\min(T_j)}, (i \in \{T_j \setminus \min(T_j)\}, 1 \le j \le K_1)$. Based on the information bits and $T_j(1 \le j \le K_1)$, values of the $K_1$ repeating bits are determined, and consequently the outer codeword $x_1^{M+K_1}$ can be determined.

Step 2: Outer codeword mapping

Outer codeword mapping is a process in which the bits of the outer codeword are mapped to the bits in a polar encoding bit sequence $u_1^N$. The set of indexes of the unfrozen bits in $u_1^N$ is $A = \{a_1, a_2, a_3, ..., a_{M+K_2}\} \subseteq \{1, 2, 3, ..., N\}$, the set of indexes of the frozen bits is $A^c$, and the unfrozen bit sequence in the polar code is $u_A = (u_{a_1}, u_{a_2}, u_{a_3}, ..., u_{a_{M+K_2}})$, where all the frozen bits are assigned with 0;

The outer codeword $x_1^{M+K_2}$ is mapped to an unfrozen bit sequence $u_A$ in such a manner that the first bit $x_1$ through the last bit $x_{M+K_2}$ in the outer codeword are mapped sequentially to the first bit $u_{a1}$ through the last bit $u_{a_{M+K_2}}$ in the unfrozen bit sequence, that is, $u_{a_k} = x_k, (k = 1, 2, 3, ..., M + K_2)$ or $u_A = x_1^{M+K_2}$;

After mapping, the $j(1 \le j \le K_1)^{\text{th}}$ repeated bit in the outer codeword is transmitted over the unfrozen bit channel $a_{\min(T_j)} = \{a_i | i = \min(T_j)\}$, and the repeating bit corresponding to the $j(1 \le j \le K_1)^{\text{th}}$ repeated bit in the outer codeword is transmitted over the unfrozen bit channel

$$a_{T_j \setminus \min(T_j)} = \{a_i | i \in T_j \setminus \min(T_j)\}.$$

Step 3: Encoding by the inner encoder.

The unfrozen bit sequence for the inner polar code obtained in Step 2 is $u_A = x_1^{M+K_2}$, and the frozen bit sequence for the polar code is comprised totally of 0s, from which a polar encoding bit sequence $u_1^N$ is derived. Based on the polar coding formula, a codeword $c_1^N = u_1^N G_N$ encoded by the concatenation system is obtained, where $G_N$ is a polar code generator matrix.

Step 4: Decoding at the receiver

Decoding is performed by using the modified SCL decoding algorithm. The essential modification is that in decoding the repeating bit, decision is made directly based on the decision result of the repeated bit, rather than based on the path metrics as in the original SCL decoding algorithm. The decoding process comprises specifically the following steps.

(4.1) It is determined whether $i$ is less than or equal to $N$. If so, proceed to (4.2). Otherwise, proceed to (4.7);

(4.2) It is determined whether $u_i$ is a frozen bit. If so, proceed to (4.3). Otherwise, proceed to (4.4);

(4.3) The decision value for $u_i$ on each current path is set to the value of a known frozen bit. Let $i = i + 1$ and return to Step (4.1). In this embodiment, the frozen bit sequence is a sequence comprised totally of 0s. Therefore, the decision value for $u_i$ on each current path is set to 0;

(4.4) It is determined whether $u_i$ is the repeating bit of the $j(1 \leq j \leq K_1)^{\text{th}}$ repetition code. If so, proceed to (4.5). Otherwise, proceed to (4.6);

(4.5) The decision value for the repeating bit $u_i$ on each current path is directly set to the decision value of the repeated bit corresponding to $u_i$ on said path: $\hat{u}_i = \hat{u}_{\min(A_{T_j})}$. Let $i = i + 1$ and return to (4.1);

$T_j$ denotes the set of indexes of all the information bits of the $j^{\text{th}}$ repetition code in the outer codeword, and $A_{T_j}$ denotes the set of indexes of all the information bits of the $j^{\text{th}}$ repetition code in the polar encoding bit sequence $u_1^N$ $u_1^N$ after outer codeword mapping, where the minimum element $\min(A_{T_j})$ in $A_{T_j}$ corresponds to the repeated bit in the $j^{\text{th}}$ repetition code, and $i \in \{A_{T_j} \setminus \min(A_{T_j})\}$ corresponds to the repeating bit of the $j^{\text{th}}$ repetition code;

(4.6) The number of current paths is denoted as $L'$, and a value of 0 or 1 may be assigned to $u_i$ on each current path, so as to obtain $2L'$ subpaths. The path metrics of the $2L'$ subpaths are respectively the probabilities of assigning a value of 0 or 1 to $u_i$ on the paths: $W_N^{(i)}(y_1^N, \hat{u}_1^{i-1} \mid 0)$ or $W_N^{(i)}(y_1^N, \hat{u}_1^{i-1} \mid 1)$. If $2L' \leq L$ ($L$ is the maximum number of paths in the SCL decoding algorithm, and $y_1^N$ denotes the received vector), the $2L'$ subpaths are reserved. If $2L' > L$, the $L$ subpaths with the maximum path metrics are reserved. Let $i = i + 1$ and return to (4.1);

(4.7) The decision sequence $\hat{u}_1^N$ for the path with the maximum path metric out of the $L$ paths is output as the decoding result;

In the decoding result $\hat{u}_1^N$, $\hat{x}_1^{M+K_2} = \hat{u}_A$ denotes the decoding result for the outer codeword. Let the set $I = \{i \mid i = 1,2,3,...,M + K_2, i \notin \{T_j \setminus \min(T_j)\}, 1 \leq j \leq K_1\}$, and $\hat{x}_I$ denotes the decoding result for the transmitted information bits.

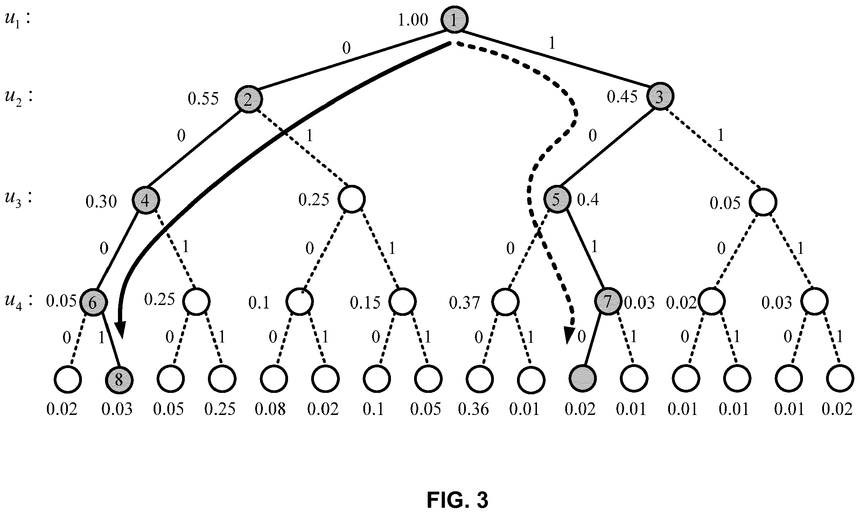

FIG. **3** is a schematic view showing a decoding process of a concatenated code of length 4 and a set $A_{T_1} = \{1,3\}$ of two-element repetition code by using a modified SCL (the maximum number of paths $L = 2$) according to the disclosure. In decoding the bit $u_3$ on two paths, since $u_3$ is a repeating bit for the information bit $u_1$, the decision value for $u_3$ can be obtained directly based on the decision result of the repeated bit $u_1 = u_{\min(A_{T_1})}$, rather than by decision based on the path metrics of the SCL decoding algorithm.

The error-correction coding method concatenating a polar code with a repetition code is described below in detail in conjunction with an embodiment.

In this embodiment, the concatenated codeword length is $N = 16$, the number of information bits is $M = 8$, the number of repeated bits is $K_1 = 4$, and the number of repeating bits is $K_2 = 4$. The outer code contains a total of four two-element repetition codes ($T_j(1 \leq j \leq 4)$, each set $T_j$ containing 2 elements). There are 12 unfrozen bit channels in the inner polar code. The polar code is constructed at a given signal-to-noise ratio to obtain an index set $A = \{a_1, a_2, a_3, ..., a_{12}\} \subseteq \{1,2,3,...,16\}$ of the unfrozen bit channels and an index set $A^c$ of the frozen bit channels. The decoder at the receiver adopts the modified SCL decoding algorithm, with the maximum number of paths set to $L$. The error-correction coding method concatenating a polar code with a repetition code according to this embodiment is described below in detail:

Step 1: Encoding by the outer encoder

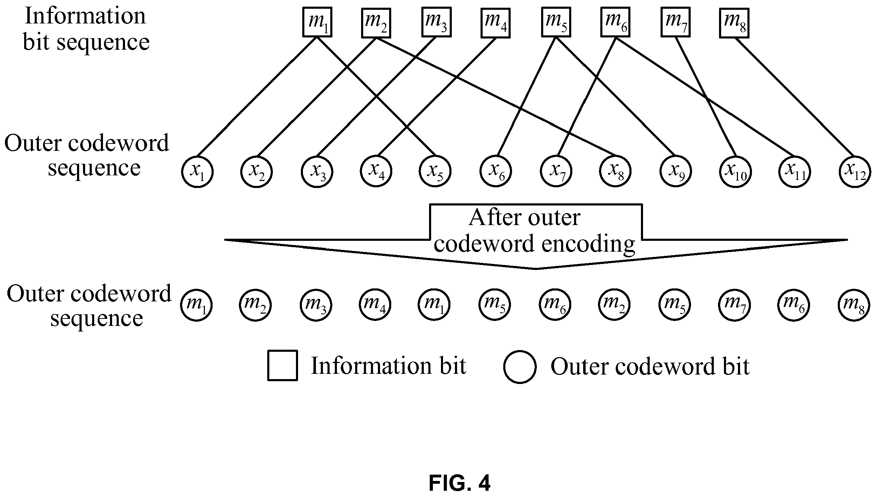

Assuming that the number of information bits is 8, the information bit sequence is $m_1^8 = (m_1, m_2, m_3, ..., m_8)$, and the number of repeating bits of the outer codeword is 4, then the outer codeword length is 12, and the outer codeword is denoted as $x_1^{12} = (x_1, x_2, x_3, ..., x_{12})$. As shown in FIG. **4,** the 4 sets of two-element repetition codes are respectively: $T_1$ = {1,5}, $T_2$ = {2,8}, $T_3$ = {6,9}, and $T_4$ = {7,11}. In encoding by the outer encoder, the index set of 8 information bits in the outer codeword is presented as follows:

$$I = \{i \mid i = 1,2,3,...,M+K_2, i \notin \{T_j \setminus \min(T_j)\}, 1 \le j \le K_1\}$$
$$= \{i \mid i = 1,2,3,...,12, i \notin \{T_j \setminus \min(T_j)\}, 1 \le j \le 4\}$$
$$= \{i \mid i = 1,2,3,...,12, i \notin \{5,8,9,11\}\}$$
$$= \{1,2,3,4,6,7,10,12\}$$

That is, $x_I = m_1^8$. According to the set $T_1$ = {1,5}, the repeating bit $x_5$ in outer codeword is $x_5 = x_1 = m_1$. The values of $x_8 = x_2 = m_2$, $x_9 = x_6 = m_5$, and $x_{11} = x_7 = m_6$ are determined sequentially based on $T_2$, $T_3$, and $T_4$, and the outer codeword $x_1^{12} = (m_1, m_2, m_3, m_4, m_1, m_5, m_6, m_2, m_5, m_7, m_6, m_8)$ is determined accordingly. Thus encoding by the outer encoder is completed.

Step 2: Outer codeword mapping.

The codeword obtained by the outer encoder is $x_1^{12}$, and the index set of unfrozen bit channels in the polar code is $A = \{a_1, a_2, a_3, ..., a_{12}\}$. The 1st through the 12th bits in the codeword $x_1^{12}$ are mapped sequentially to the 1st through the 12th unfrozen bits in the polar code, resulting in an unfrozen bit sequence $u_A = x_1^{12}$ for the polar code;

After mapping, the $j$th repeated bit in the outer codeword is transmitted over the unfrozen bit channel $a_{\min(T_j)} = \{a_i \mid i = \min(T_j)\}, (1 \le j \le 4)$, and the repeating bit corresponding to the $j$th repeated bit in the outer code is transmitted over the unfrozen bit channel $a_{T_j \setminus \min(T_j)} = \{a_i \mid i \in T_j \setminus \min(T_j)\}$.

With regard to the four sets $T_j(1 \le j \le 4)$ obtained in Step 1, the four repeated bits in the outer codeword are transmitted over the unfrozen bit channels $a_{\min(T_j),1 \le j \le 4} = \{a_1, a_2, a_6, a_7\}$, and the four repeating bits in the outer codeword are transmitted over the unfrozen bit channels $a_{T_j \setminus \min(T_j), 1 \le j \le 4} = \{a_5, a_8, a_9, a_{11}\}$.

Step 3: Encoding by the inner encoder.

The unfrozen bit sequence for the inner polar code obtained in Step 2 is $u_A = x_1^{12}$, and the frozen bit sequence for the polar code is comprised totally of 0s, from which the polar encoding bit sequence $u_1^{16}$ is derived. Based on the polar coding formula, a codeword encoded by the concatenation system $c_1^{16} = u_1^{16} G_N$ is obtained, where $G_N$ is a generator matrix of a polar code.

Step 4: Decoding by the concatenation system.

In this embodiment, a modified SCL decoding method is used for decoding by the concatenation system. For a first set of two-element repetition codes $T_1 = \{1,5\}$, when decoding the unfrozen bit $u_{a5}$, the decision for the bit $u_{a5}$ in each path is obtained based on the decision value of the repeated bit $u_{a1}$, i.e., $\hat{u}_{a5} = \hat{u}_{a1}$. For decision of a bit other than the repeating bits, decision is made according to the conventional SCL decoding algorithm. According to such a modified SCL decoding algorithm, the decoding result $\hat{u}_1^{16}$ is obtained for the code. In the decoding result $\hat{u}_1^{16}$, $\hat{x}_1^{12} = \hat{u}_A$ is the decoding result for the outer codeword. Let the set $I = \{1,2,3,4,6,7,10,12\}$, then $\hat{x}_I$ is the decoding result for the transmitted information bits.

The error-correction coding method concatenating a polar code with a multi-bit parity-check code is described below in detail:

Step 1: Encoding by the outer encoder.

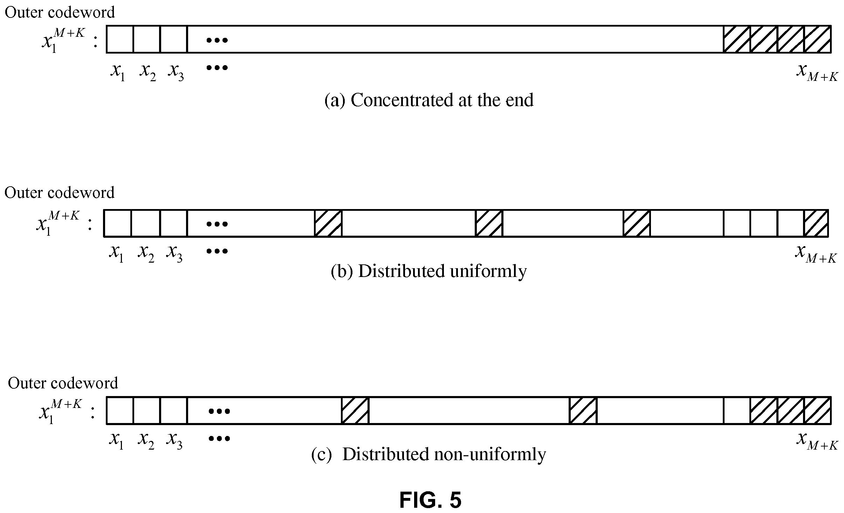

For a concatenation system with a codeword length $N$, a number of information bits $M$, and a number of parity bits $K$, the length of input information sequence for the outer code is $M$, and the length of output outer codeword is $M + K$. Assume that the outer codeword is $x_1^{M+K}$, and $x_1^{M+K}$ contains $M$ information bits and $K$ parity bits. In the concatenation system of a polar code with a multi-bit parity-check code, the outer code contains $K$ parity functions, each of which consists of a parity bit and the information bits corresponding to the parity bit, and the $j(1 \leq j \leq K)^{th}$ parity function in the outer code denotes the parity function containing the $j^{th}$ parity bit; As shown in FIG. **5,** depending on the distribution of locations of the $K$ parity bits of the outer codeword, the disclosure provides three methods for determining the locations of the parity bits:

Method 1: The parity bits are concentrated at the end of the outer codeword. As shown in FIG. **5(a),** the set of indexes of the parity bits is $P = \{M + 1, M + 2, M + 3,..., M + K\}$. The elements in the set $P$ represent bit indexes in the outer code where the parity bits are located. That is, in the outer codeword $x_1^{M+K}$, the bit sequence $x_1^M$ is comprised of information bits, and the bit sequence $x_{M+1}^{M+K}$ is comprised of parity bits.

Method 2: The parity bits are distributed uniformly in the outer codeword. As shown in FIG. **5(b),** the codeword length of the outer code is $M + K$, the interval between adjacent parity bits is $\left\lfloor \dfrac{M+K}{K} \right\rfloor$, where $\lfloor x \rfloor$ denotes a floor function of $x$, and the set of indexes of the parity bits is

$$P = \{ \left\lfloor \frac{M+K}{K} \right\rfloor \cdot j, j = 1,2,3...,K \}.$$

Method 3: The parity bits are distributed non-uniformly in the outer codeword. As shown in FIG. **5(c),** in this method, the distribution characteristic of parity bits in Method 3 is that the closer to the beginning of the outer codeword, the more dispersed the distribution of the parity bits, and the closer to the end of the outer codeword, the more concentrated the distribution of the parity bits. According to this characteristic of the distribution of the parity bit locations, an index set $P$ of the parity bits is obtained.

In specific implementation, Method 3 may be a combination of Method 1 and Method 2 described above. Specifically, some parity bits are concentrated at the end, and the other parity bits are distributed uniformly. Assuming that the number of parity bits concentrated at the end is $K_1$, then the number of parity bits distributed uniformly at the front is $K - K_1$. It is obtained that the set of indexes of the parity bits is:

$$P = \{ P_1 \bullet P_2 \mid P_1 = \{M+K-K_1+1, M+K-K_1+2,..., M+K\}, P_2 = \{ \left\lfloor \frac{M+K-K_1}{K-K_1} \right\rfloor \cdot j, j = 1,2,3,...,K-K_1 \} \} \cdot$$

When $K_1 = 0$, the set $P_1$ is an empty set, in which case Method 3 is equivalent to Method 1. When $K_1 = K$, the set $P_2$ is an empty set, in which case Method 3 is equivalent to Method 2.

Assume that the index set of parity bits determined by using one of the three methods described above is denoted as $P = \{p_1, p_2, p_3,..., p_K\} \subseteq \{1,2,3...,M + K\}$, where $p_j$ denotes the index of the $j(j = 1,2,3,...,K)^{th}$ parity bit among the bits of the outer codeword, and the set of indexes of all the information bits from the parity function containing the

parity bit $x_{p_j}$ in the outer codeword is denoted as $T_j$, where $T_j$ satisfies $T_j \subseteq \{1,2,3,...,p_j\}$, and $p_j$ belongs to $T_j$, i.e., $p_j = \max(T_j)$, such that the parity bit only checks the information bits before and is irrelevant to the information bits after. The

$$x_{p_j} = (\sum_{i \in T_j \setminus \max(T_j)} x_i) \bmod 2, \, j = 1, 2, 3, ..., K .$$

parity bit $x_{p_j}$ is assigned with a value of                    Then encoding of the outer code is completed.

Step 2: Outer codeword mapping.

Outer codeword mapping is a process in which the bits of the outer codeword are mapped to the bits in a polar encoding bit sequence $u_1^N$. Assume that the set of indexes of the unfrozen bits in $u_1^N$ is $A = \{a_1, a_2, a_3, ..., a_{M+K}\} \subseteq \{1,2,3,...,N\}$, the set of indexes of the frozen bits in $u_1^N$ is $A^c$, the unfrozen bit sequence in the polar code is $u_A = (u_{a_1}, u_{a_2}, u_{a_3}, ..., u_{a_{M+K}})$, and all the frozen bits are assumed to be 0. The outer codeword $x_1^{M+K}$ is mapped to the unfrozen bit sequence $u_A$ in such a manner that the first bit $x_1$ through the last bit $x_{M+K}$ in the outer codeword are mapped sequentially to the first bit $u_{a_1}$ through the last bit $u_{a_{M+K}}$ in the unfrozen bit sequence. That is, $u_{a_k} = x_k, (k = 1,2,3,...,M + K)$ or $u_A = x_1^{M+K}$.

As is known after mapping, parity bits in the outer codeword are transmitted over the unfrozen bit channels $A_P = \{a_i \mid i \in P\}$, the $j(j = 1,...,K)$th parity bit in the outer codeword is transmitted over the unfrozen bit channel $a_{p_j}$ and all the information bits in the $j$th parity function of the outer codeword are transmitted over the unfrozen bit channels $A_{T_j} = \{a_i \mid i \in T_j, i \neq \max(T_j)\}$.

Step 3: Encoding by the inner encoder.

The unfrozen bit sequence in the inner polar code obtained in Step 2 is $u_A = x_1^{M+K}$, and the frozen bit sequence in the polar code is comprised totally of 0s, from which a polar encoding bit sequence $u_1^N$ is derived. Based on the polar coding formula, a codeword encoded by the concatenation system $c_1^N = u_1^N G_N$ is obtained, where $G_N$ is a polar code generator matrix.

Step 4: Decoding at the receiver.

The decoder for the concatenation system uses a modified SCL decoding algorithm. The essential modification lies in that, in decoding the parity bit, decision is made by checking result based on the decision values of the information bits in the parity function that contains the parity bit, rather than based on the path metrics as in the original SCL decoding algorithm.

The decoding process comprises specifically the following steps.

Initialization of the input: $i = 1$, and the maximum number of paths in the decoder is $L$.

In Step 1, it is determined whether $i$ is less than or equal to $N$. If so, proceed to Step 2. Otherwise, proceed to Step 7.

In Step 2, it is determined whether $u_i$ is a frozen bit. If so, proceed to Step 3. Otherwise, proceed to Step 4.

In Step 3, the decision value for $u_i$ on each current path is set to 0. Let $i = i + 1$ and return to Step 1.

In Step 4, it is determined whether $u_i$ is the $j(1 \leq j \leq K)$th parity bit. If so, proceed to Step 5. Otherwise, proceed to Step 6.

In Step 5, the decision value for $u_i$ on each current path is obtained by checking result based on the decision

$$\hat{u}_i = (\sum_{h \in \{A_{T_j} \setminus \max(A_{T_j})\}} \hat{u}_h) \bmod 2 .$$

values of the information bits on the path:                    Let $i = i + 1$ and return to Step 1.

In Step 6, the number of current paths is denoted as $L'$, and $u_i$ on each current path may be assigned with a value of 0 or 1, so as to obtain $2L'$ subpaths. The path metrics of the $2L'$ subpaths are respectively the probabilities of assigning a value of 0 or 1 to $u_i$ on the paths: $W_N^{(i)}(y_1^N, \hat{u}_1^{i-1} \mid 0)$ or $W_N^{(i)}(y_1^N, \hat{u}_1^{i-1} \mid 1)$. If $2L' \leq L$, the $2L'$ subpaths are

reserved. If $2L' > L$, the $L$ subpaths with the maximum path metrics are reserved. Let $i = i + 1$ and return to Step 1.

In Step 7, the decision sequence $\hat{u}_1^N$ for the path with the maximum path metric out of the $L$ paths is output.

In Step 8: End.

In the decoding result $\hat{u}_1^N$, $\hat{x}_1^{M+K} = \hat{u}_A$ is the decoding result for the outer codeword. Let the set $I = \{i \mid i = 1,2,3,...,M + K, i \notin P\}$, then $\hat{x}_I$ is the decoding result for the transmitted information bits.

The error-correction coding method concatenating a polar code with a multi-bit parity-check code according to the disclosure will be explained below in detail in conjunction with an embodiment.

In this embodiment, the concatenated codeword length is $N = 512$, the number of information bits is $M = 240$, and the number of parity bits is $K = 16$, from which it is known that the number of unfrozen bit channels in the inner polar code is 256, and the number of frozen bit channels in the inner polar code is 256. Assume that polar code is constructed at the signal-to-noise ratio 2 dB, a set of indexes of the unfrozen bit channels $A = \{a_1, a_2, a_3,..., a_{256}\} \subseteq \{1,2,3,...,512\}$ and a set of indexes of the frozen bit channels $A^c$ are obtained respectively. The decoder at the receiver uses the modified SCL decoding algorithm, with the maximum number of paths set to $L = 32$.

Step 1: Encoding by the outer encoder.

Assume that the number of information bits is 240, and the number of parity bits is 16, then the codeword length of the outer code is 256, and the outer codeword is denoted as $x_1^{256}$. In an embodiment, a set $P$ of indexes of the parity bits is obtained as follows by using respectively the three methods described above for determining the set $P$ :

In Method 1, the parity bits are concentrated at the end of the outer codeword. Specifically, among the bits in the outer codeword $x_1^{256}$, the last 16 bits, i.e., $x_{241}^{256}$, are parity bits, and the first 240 bits, i.e., $x_1^{240}$, are information bits. Accordingly, a set $P = \{241,242,243,244,245,246,247,248,249,250,251,252,253,254,255,256\}$ is obtained.

In Method 2, the parity bits are distributed uniformly in the outer codeword. Specifically, among the bits in the outer codeword $x_1^{256}$, $x_{1\times16}, x_{2\times16}, x_{3\times16}, ..., x_{16\times16}$ are parity bits, and the other 240 bits are information bits. Accordingly, a set $P = \{16,32,48,64,80,96,112,128,144,160,176,192,208,224,240,256\}$ is obtained.

In Method 3, the parity bits are distributed non-uniformly in outer codeword. Assume that the parity bits are distributed non-uniformly in such a manner that the number of parity bit concentrated at the end is $K_1 = 8$, and the number of parity bits distributed uniformly at the front is $K - K_1 = 8$. As such, among the bits in the outer code $x_1^{256}$, $x_{1\times31}, x_{2\times31}, x_{3\times31}, ..., x_{8\times31}, x_{249}, x_{250}, x_{251}, ..., x_{256}$ are parity bits, and the other 240 bits are information bits. In this example, a set $P = \{31,62,93,124,155,186,217,248,249,250,251,252,253,254,255,256\}$ is obtained.

Taking a set $P$ obtained by using Method 2 as an example, the determination of information bit indexes in each parity function and encoding of each parity function will be described.

Given $P = \{16,32,48,64,80,96,112,128,144,160,176,192,208,224,240,256\}$, i.e., the parity bit in the first parity function is $x_{16}$, all the information bits in this function will be selected from the set $S_1 = \{1,2,3,...,16\}$, and the index $p_1 = 16$ of the parity bit is necessarily selected. Each element in the set $S_1 \setminus \max(S_1)$ is selected as a participant for the parity function or not with a probability of $\alpha = 0.5$, then, one can obtain the index set $T_1 = \{6,8,10,11,16\}$ corresponding to the first parity function, and accordingly, the coding formula for the first parity bit $x_{16}$ is:

$$x_{16} = x_6 \oplus x_8 \oplus x_{10} \oplus x_{11} \tag{1}$$

The value of the other 15 parity bits may also be determined in the manner described above, and then encoding of the outer code is completed.

Step 2: Outer codeword mapping.

It is known that the codeword obtained by the outer encoder is $x_1^{256}$, and the index set of unfrozen bit channels in the polar code is $A = \{a_1, a_2, a_3,..., a_{256}\}$. The 1st through the 256th bits in the codeword $x_1^{256}$ are mapped sequentially to the 1st through the 256th unfrozen bits in the polar code, resulting in an unfrozen bit sequence $u_A = x_1^{256}$ in the polar code.

It is known after mapping that parity bits in the outer codeword are transmitted over the unfrozen bit channels $A_P = \{a_i \mid i \in P\}$, the $j(j = 1,...,16)^{th}$ parity bit in the outer codeword is transmitted over the unfrozen bit channel $a_{p_j}$, and all the information bits in the $j^{th}$ parity function of the outer codeword are transmitted over the unfrozen bit channels $A_{T_j} = \{a_i \mid i \in T_j\}$. Taking $P = \{16,32,48,64,80,96,112,128,144,160,176,192,208,224,240,256\}$ obtained by using Method 2 as an example, parity bits in the outer codeword are transmitted over the unfrozen bit channels

$A_P = \{a_i \mid i \in P\} = \{a_{16},a_{32},a_{48},a_{64},a_{80},a_{96},a_{112},a_{128},a_{144},a_{160},a_{176},a_{192},a_{208},a_{224},a_{240},a_{256}\}$; the 1st parity bit in the outer codeword is transmitted over the unfrozen bit channel $a_{p_1} = a_{16}$; and all the information bits in the first parity function of the outer codeword are transmitted over the unfrozen bit channels $A_{T_1} = \{a_i \mid i \in T_1\} = \{a_6,a_8,a_{10},a_{11},a_{16}\}$. The values of $A_{T_j},a_{p_j}(j = 2,3,4,...,16)$ are obtained sequentially.

Step 3: Encoding by the inner encoder.

The unfrozen bit sequence in the inner polar code obtained in Step 2 is $u_A = x_1^{256}$, and the frozen bit sequence in the polar code is comprised totally of 0s, from which the polar encoding bit sequence $u_1^{512}$ is derived. Based on the polar coding formula, a codeword encoded by the concatenation system $c_1^{512} = u_1^{512} G_N$ is obtained, where $G_N$ is a generator matrix of a polar code.

Step 4: Decoding by the concatenation system.

A modified SCL decoding algorithm is used for decoding by the concatenation system. The essential difference between this algorithm and the original SCL decoding algorithm lies in that, in decoding a parity bit, the decision value for the parity bit is obtained directly by checking result based on the decision values of the information bits in the parity function. Taking the first parity function as an example, when decoding the bit $u_{a_{16}}$, decision for the bit $u_{a_{16}}$ in 32 paths is obtained by checking result based on the decision values of the information bits in the first parity function, using a formula of:

$$\hat{u}_{a_{16}} = \hat{u}_{a_6} \oplus \hat{u}_{a_8} \oplus \hat{u}_{a_{10}} \oplus \hat{u}_{a_{11}} \qquad (2)$$

For decision of a bit other than parity bits, decision is made according to the conventional SCL decoding algorithm. According to this modified SCL decoding algorithm, a decoding result $\hat{u}_1^{512}$ is obtained for the concatenated code. In the decoding result $\hat{u}_1^{512}$, $\hat{x}_1^{M+K} = \hat{u}_A$ is the decoding result for the outer codeword. Let the set $I = \{i \mid i = 1,2,3,...,256, i \notin P\}$, then $\hat{x}_I$ is the decoding result for the transmitted information bits.

While particular embodiments of the invention have been shown and described, it will be obvious to those skilled in the art that changes and modifications may be made without departing from the invention in its broader aspects, and therefore, the aim in the appended claims is to cover all such changes and modifications as fall within the true spirit and scope of the invention.

**Claims**

1. An error-correction coding method, the method comprising:

   (1) performing repetition coding or multi-bit parity-check coding on an information bit sequence, to yield an outer codeword;
   (2) sequentially mapping a first bit to a last bit of the outer codeword on a first unfrozen bit to a last unfrozen bit of a polar code, to yield an unfrozen bit sequence; and
   (3) performing polar coding on the unfrozen bit sequence, to yield a concatenated codeword.

2. The method of claim 1, **characterized in that** in (1), an information bit to be repeated is repeated one or more times during the repetition coding.

3. The method of claim 2, **characterized in that** in (2), in the process of mapping, the bit channel capacities of unfrozen bit channels mapped by repeated bits are lower than those of the unfrozen bit channels mapped by unrepeated bits, where the repeated bits denote the information bits that are repeated in the repetition coding, and the unrepeated bits denote the information bits that are not repeated.

4. The method of claim 2 or 3, **characterized in that** in (2), in the process of mapping, the indexes of the unfrozen bits mapped by repeating bits of the outer codeword are greater than the index of the unfrozen bit mapped by the repeated bit corresponding to the repeating bits, where the repeating bits denotes the bits in the repetition code that repeat the repeated bit.

5. The method of claim 4, **characterized in that** the repeating bits of the outer codeword are distributed uniformly or approximately uniformly in the unfrozen bit sequence.

6. The method of claim 5, **characterized in that** by dividing the unfrozen bit sequence into $S$ segments in the order of the indexes, the repeating bits of the outer codeword are mapped to $K_h$ unfrozen bit channels of the lowest bit channel capacities in each segment, with the same number or approximately the same number of repeating bits in each segment, such that the repeating bits of the outer codeword are distributed uniformly or approximately uniformly in the unfrozen bits, where $h$ = 1,2,...,$S$.

7. The method of claim 4, **characterized in that:**

   the outer codeword is an inverted repetition code;
   when the repeated bit is 1, the repeating bit of the inverted repetition code is 0, and when the repeated bit is 0, the repeating bit of the inverted repetition code is 1; and
   when the repeated bit is repeated for $K$ times, the number of inversed repeating bits out of the $K$ repeating bits obtained by repetition coding is 0-$K$.

8. The method of claim 4, **characterized in that** certain bits at an end of the outer codeword are used as parity bits, and each of the parity bits serves as an even or odd-parity bit for information bits corresponding to the parity bit, where an even parity bit denotes a bit whose value is 0(or 1) if the number of 1s in its corresponding information bits is even (or odd), an odd parity bit denotes a bit whose value is 1(or 0) if the number of 1s in its corresponding information bits is even (or odd).

9. The method of claim 4, **characterized in that** the error-correction coding method further comprises a decoding process as follows: (4) deciding an original information bit according to the SCL decoding algorithm; and deciding the repeating bit directly based on a decision result of the repeated bits.

10. The method of claim 9, **characterized in that** the decoding process comprises:

    (4.1): determining whether $i$ is less than or equal to $N$; and if so, proceeding to (4.2), otherwise, proceeding to (4.7); where $N$ is a codeword length of a concatenated code, and $i$ is an index of an $i$th bit currently being decoded, and has an initial value of 1 and is assigned with a positive integer from 1 to $N$;
    (4.2): determining whether $u_i$ is a frozen bit, and if so, proceeding to (4.3), otherwise, proceeding to (4.4), where

    $u_i$ is the $i$th bit in the polar encoding bit sequence $u_1^N$ and $u_1^N$ is a row vector $(u_1,u_2,u_3,...,u_N)$ in $1 \times N$;
    (4.3): setting a decision value for $u_i$ on each path to a value of a known frozen bit, letting $i = i + 1$, and returning to (4.1);
    (4.4): determining whether $u_i$ is a repeating bit of the $j(1 \leq j \leq K)$th repetition code, and if so, proceeding to (4.5), otherwise, proceeding to (4.6), where $K$ is the number of repeated bits in the outer code, and $1 \leq j \leq K$;
    (4.5): setting the decision value for the repeating bits $u_i$ on each current path to the decision value of the repeated

    bit corresponding to $u_i$ on the path, specifically, $\hat{u}_i = \hat{u}_{\min(A_{T_j})}$, letting $i = i + 1$, and returning to (4.1);
    where $T_j$ is a set of indexes of all the information bits in the $j$th repetition code in the outer codeword, $A_{T_j}$ is a

    set of indexes of all the information bits in the $j$th repetition code in the polar encoding bit sequence $u_1^N$ after outer codeword mapping, and $\min(A_{T_j})$ is a minimum element in the value set $A_{T_j}$;
    (4.6): denoting the number of current paths as $L'$, obtaining $2L'$ subpaths by assigning a value of 0 or 1 to $u_i$ on

each current path, and determining whether $2L' \leq L$ is satisfied, and if so, reserving $2L'$ subpaths, otherwise, reserving $L$ subpaths with the maximum path metrics, letting $i = i + 1$ and returning to (4.1);

where the metrics of the $2L'$ subpaths are respectively the probabilities $W_N^{(i)}(y_1^N, \hat{u}_1^{i-1} \mid 0)$ or $W_N^{(i)}(y_1^N, \hat{u}_1^{i-1} \mid 1)$ of assigning 0 or 1 to $u_i$ on the paths, $L$ is the maximum number of paths in the SCL decoding algorithm; and

(4.7): obtaining a decoding result by outputting a decision sequence $\hat{u}_1^N$ corresponding to the path with the maximum path metric out of the $L$ paths.

11. The method of claim 1, **characterized in that:**

the parity bits of the outer codeword obtained by performing multi-bit parity-check coding on the information bit sequence in (1) are concentrated at the end of the outer codeword;
the set of indexes of the parity bits is $P = \{M + 1, M + 2, M + 3,...,M + K\}$, and the elements in the set $P$ represent the bit indexes in the outer codeword where the parity bits are located; that is, in the codeword $x_1^{M+K}$ generated by an outer encoder, the bit sequence $x_1^M$ is information bits, and the bit sequence $x_{M+1}^{M+K}$ is parity bits; and where $M$ is a number of information bits, and $K$ is a number of parity bits.

12. The method of claim 1, **characterized in that:**

the parity bits of the outer codeword obtained by performing multi-bit parity-check coding on the information bit sequence in (1) are distributed uniformly in the outer codeword;

the interval between adjacent parity bits is $\left\lfloor \dfrac{M + K}{K} \right\rfloor$, and the set of indexes of the parity bits is

$$P = \{\left\lfloor \frac{M + K}{K} \right\rfloor \cdot j, j = 1, 2, 3...,K\};$$
and

where $M$ is a number of information bits, $K$ is a number of parity bits, $M + K$ is the outer codeword length, and $\lfloor x \rfloor$ is a floor function of $x$.

13. The method of claim 1, **characterized in that** the parity bits of the outer codeword obtained by performing multi-bit parity-check coding on the information bit sequence in (1) are distributed non-uniformly in the outer codeword.

14. The method of claim 13, **characterized in that** assuming that the number of parity bits concentrated at the end of the outer codeword is $K_1$, then the number of preceding parity bits distributed uniformly is $K - K_1$, and the set of indexes of the parity bits is:

$$P = \{P_1 \bullet P_2 \mid P_1 = \{M + K - K_1 + 1, M + K - K_1 + 2,...,M + K\}, P_2 = \{\left\lfloor \frac{M + K - K_1}{K - K_1} \right\rfloor \cdot j, j = 1, 2, 3,...,K - K_1\}\}$$

; where $M$ is the number of information bits, and $K$ is the number of parity bits

15. The method of one of claims 1, 11-14, **characterized in that** when multi-bit parity-check coding is performed on the information bit sequence in (1), the parity bit is used only to check the information bits before and not the information bits after.

16. The method of claim 15, **characterized in that** the outer code is replaced with a multi-bit odd-parity code, whose parity bits are odd parity bits.

17. The method of claim 15, **characterized in that** the decoding process for the coding method described above is performed by using a modified SCL decoding algorithm; in decoding the information bit, bit decision is performed according to the conventional SCL decoding algorithm, and in decoding the parity bit, decision is made by checking result based on the decision values of the information bits in the parity function containing the parity bit, where a parity function denotes the mathematical relationship between a parity bit and its corresponding information bits.

**18.** The method of claim 17, **characterized in that** the decoding process comprises:

step 1: determining whether $i$ is less than or equal to $N$, and if so, proceeding to step 2, otherwise, proceeding to step 7, where $N$ is the codeword length of the concatenated code, and $i$ is the index of the $i^{th}$ bit being decoded, and has an initial value of 1 and is assigned with a positive integer from 1 and $N$;

step 2: determining whether $u_i$ is a frozen bit, and if so, proceeding to step 3, otherwise, proceeding to step 4, where $u_i$ is the $i^{th}$ bit in the polar encoding bit sequence;

step 3: setting the decision value for $u_i$ on each current path to the value of a known frozen bit, letting $i = i + 1$, and returning to step 1;

step 4: determining whether $u_i$ is the $j(j = 1,2,...,K)^{th}$ parity bit, and if so, proceeding to step 5, otherwise, proceeding to step 6, where $K$ is the number of parity bits;

step 5: obtaining a decision value for $u_i$ on each current path by checking result based on the decision values of the information bits on the path:

$$\hat{u}_i = (\sum_{h \in A_{T_j} \setminus \max(A_{T_j})} \hat{u}_h) \bmod 2,$$

letting $i = i + 1$, and returning to step 1;

where $T_j$ is a set of indexes of all the information bits from the $j^{th}$ parity function in the outer code, and the outer code contains $K$ parity functions, each of which consists of a parity bit and the information bits corresponding to the parity bit, and the $j^{th}$ parity function denotes a parity function containing the $j^{th}$ parity bit, $A_{T_j}$ is a set of indexes of all the information bits from the $j^{th}$ parity function in the polar encoding bit sequence $u_1^N$ after outer codeword mapping, $\max(A_{T_j})$ denotes the maximum element in the value set $A_{T_j}$ and is the index of the parity bit from the $j^{th}$ parity function mapped into $u_1^N$; $h$ is a temporary variable in said sum operation, denoting each element in the set $A_{T_j} \setminus \max(A_{T_j})$ sequentially, and $A_{T_j} \setminus \max(A_{T_j})$ denotes the difference between the value sets $A_{T_j}$ and $\max(A_{T_j})$, where $A_{T_j} \setminus \max(A_{T_j}) = \{\lambda \mid \lambda \in A_{T_j}, \lambda \neq \max(A_{T_j})\}$;

step 6: denoting the number of current paths as $L'$, and obtaining $2L'$ subpaths by assigning a value of 0 or 1 to $u_i$ on each current path, where the path metrics for the $2L'$ subpaths are respectively the probabilities $W_N^{(i)}(y_1^N, \hat{u}_1^{i-1} \mid 0)$ or $W_N^{(i)}(y_1^N, \hat{u}_1^{i-1} \mid 1)$ of assigning 0 or 1 to $u_i$ on the paths;

if $2L' \leq L$, reserving $2L'$ subpaths, otherwise, if $2L' > L$, reserving $L$ subpaths with the maximum path metrics, letting $i = i + 1$ and returning step 1;

where $L$ is the maximum number of paths in the SCL decoding algorithm, and $y_1^N$ denotes the received vector;

step 7: outputting the decision sequence $\hat{u}_1^N$ corresponding to the path with the maximum path metric out of the $L$ paths; and

step 8: end.

**FIG. 1**

```
┌─────────────────────────────────────┐
│      Information bit sequence        │
└─────────────────────────────────────┘
                   │
                   ▼
┌─────────────────────────────────────┐
│  Encoding of multi-bit parity-check  │
│      code or repetition code         │
└─────────────────────────────────────┘
                   │
                   ▼
┌─────────────────────────────────────┐
│       Encoding of polar code         │
└─────────────────────────────────────┘
                   │
                   ▼
┌─────────────────────────────────────┐
│             Channels                 │
└─────────────────────────────────────┘
                   │
                   ▼
┌─────────────────────────────────────┐
│       Modified SCL decoding          │
└─────────────────────────────────────┘
                   │
                   ▼
┌─────────────────────────────────────┐
│     Outputting of decoding result    │
└─────────────────────────────────────┘
```

**FIG. 2**

FIG. 3

FIG. 4

EP 3 364 542 A1

Outer codeword

$$x_1^{M+K} :$$

$x_1$  $x_2$  $x_3$  •••

$x_{M+K}$

(a) Concentrated at the end

Outer codeword

$$x_1^{M+K} :$$

$x_1$  $x_2$  $x_3$  •••

$x_{M+K}$

(b) Distributed uniformly

Outer codeword

$$x_1^{M+K} :$$

$x_1$  $x_2$  $x_3$  •••

$x_{M+K}$

(c) Distributed non-uniformly

**FIG. 5**

# INTERNATIONAL SEARCH REPORT

| International application No. |
| --- |
| PCT/CN2016/108511 |

### A. CLASSIFICATION OF SUBJECT MATTER

H03M 13/29 (2006.01) i; H03M 13/13 (2006.01) i

According to International Patent Classification (IPC) or to both national classification and IPC

### B. FIELDS SEARCHED

Minimum documentation searched (classification system followed by classification symbols)

H03M; H04L

Documentation searched other than minimum documentation to the extent that such documents are included in the fields searched

Electronic data base consulted during the international search (name of data base and, where practicable, search terms used)

WPI, EPODOC, CNPAT, CNKI, IEEE: polar, codes, parity, even, odd, check, equal, uniform, distance, interval

### C. DOCUMENTS CONSIDERED TO BE RELEVANT

| Category* | Citation of document, with indication, where appropriate, of the relevant passages | Relevant to claim No. |
| --- | --- | --- |
| Y | SUN, Qian. "Research on Multilevel Coded Modulation System Based on Concatenated Polar Codes", China Master's Theses Full-text Database, 15 May 2015 (15.05.2015), ISSN: 1674-0246, sections 2.1.1 and 3.2.1 | 1-18 |
| Y | SARKIS, Gabi et al. "Fast List Decoders for Polar Codes", IEEE Journal on Selected Areas In Communications, vol.34, no.2, 30 November 2015 (30.11.2015), ISSN: 0733-8716, pages 318-326 | 1-18 |
| Y | CHEN, Kai. "Research on Polar Coding Theory and Practical Applications", China Doctoral Dissertations Full-text Database, 15 April 2015 (15.04.2015) , ISSN: 1674-022X, section 3.3.1 | 9, 10, 17, 18 |
| PX | CN 105680883 A (HUAZHONG UNIVERSITY OF SCIENCE AND TECHNOLOGY) 15 June 2016 (15.06.2016) claims 1-9 | 1, 11-18 |
| A | CN 1691544 A (BEIJING SAMSUNG COMMUNICATION TECHNOLOGY RESEARCH CO., LTD. et al.) 02 November 2005 (02.11.2005) the whole document | 1-18 |

☒ Further documents are listed in the continuation of Box C.  ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&"document member of the same patent family |

| Date of the actual completion of the international search | Date of mailing of the international search report |
| --- | --- |
| 16 February 2017 | 21 March 2017 |

| Name and mailing address of the ISA State Intellectual Property Office of the P. R. China No. 6, Xitucheng Road, Jimenqiao Haidian District, Beijing 100088, China Facsimile No. (86-10) 62019451 | Authorized officer SHEN, Minjie Telephone No. (86-10) 62414017 |
| --- | --- |

Form PCT/ISA /210 (second sheet) (July 2009)

EP 3 364 542 A1

## INTERNATIONAL SEARCH REPORT

| | International application No. |
|---|---|
| | PCT/CN2016/108511 |

C (Continuation). DOCUMENTS CONSIDERED TO BE RELEVANT

| Category* | Citation of document, with indication, where appropriate, of the relevant passages | Relevant to claim No. |
|---|---|---|
| A | CN 102694625 A (BEIJING POSTS & TELECOMMUNICATION UNIVERSITY) 26 September 2012 (26.09.2012) the whole document | 1-18 |
| A | CN 103220001 A (HUAWEI TECHNOLOGIES CO., LTD.) 24 July 2013 (24.07.2013) the whole document | 1-18 |
| A | CN 103746708 A (CHINA AGRICULTURAL UNIVERSITY) 23 April 2014 (23.04.2014) the whole document | 1-18 |
| A | CN 103516476 A (HUAWEI TECHNOLOGIES CO., LTD.) 15 January 2014 (15.01.2014) the whole document | 1-18 |

Form PCT/ISA /210 (continuation of second sheet ) (July 2009)

24

## INTERNATIONAL SEARCH REPORT
### Information on patent family members

International application No.

PCT/CN2016/108511

| Patent Documents referred in the Report | Publication Date | Patent Family | Publication Date |
|---|---|---|---|
| CN 105680883 A | 15 June 2016 | None | |
| CN 1691544 A | 02 November 2005 | None | |
| CN 102694625 A | 26 September 2012 | None | |
| CN 103220001 A | 24 July 2013 | WO 2013107140 A1 | 25 July 2013 |
| | | EP 2802080 A1 | 12 November 2014 |
| | | US 2014365842 A1 | 11 December 2014 |
| CN 103746708 A | 23 April 2014 | None | |
| CN 103516476 A | 15 January 2014 | US 2015103947 A1 | 16 April 2015 |
| | | EP 2849377 A1 | 18 March 2015 |
| | | WO 2014000532 A1 | 03 January 2014 |

Form PCT/ISA/210 (patent family annex) (July 2009)